# FASCICULE DE BREVET EUROPEEN

(11) **EP 3 098 830 B1**
(45) Date de publication et mention de la délivrance du brevet: **07.11.2018**
(21) Numéro de dépôt: 16168024.4
(22) Date de dépôt: 03.05.2016
(51) Int. Cl.: H01H 33/668, H01H 9/54

(54) **DISPOSITIF DE SURVEILLANCE DE DÉCHARGES PARTIELLES DANS UN RÉSEAU ÉLECTRIQUE**
ÜBERWACHUNGSVORRICHTUNG DER TEILENTLADUNGEN EINES STROMNETZES
DEVICE FOR MONITORING PARTIAL DISCHARGES IN AN ELECTRICAL NETWORK

(30) Priorité: 28.05.2015 FR 1554807
(43) Date de publication de la demande: 30.11.2016
(73) Titulaire: Schneider Electric Industries SAS, 92500 Rueil-Malmaison (FR)
(72) Inventeur: Schellekens, Hans, 38660 La Terrasse (FR); Preve, Christophe, 38700 La Tronche (FR)
(74) Mandataire: Dufresne, Thierry

(56) Documents cités:
- CN-A- 103 413 721
- CN-U- 203 491 185
- JP-A- 2014 216 208
- US-A- 4 103 291

## Description

### Domaine technique de l'invention

L'invention concerne un dispositif de surveillance de décharges partielles, survenant dans un réseau électrique alternatif moyenne tension ou haute tension notamment un réseau triphasé.

L'invention s'applique plus particulièrement à des appareils de coupure, tels que des interrupteurs ou disjoncteurs à vide, de type isolés par un gaz ou par des isolants solides ou par une combinaison de gaz avec une paroi isolante, et a notamment pour but de faire la distinction entre des décharges partielles provenant d'une perte de vide dans l'interrupteur ou le disjoncteur à vide et des décharges partielles provenant d'une autre cause.

### Etat de la technique

Il est connu, voir par exemple les documents US4103291 et EP2463883, de surveiller la qualité du vide dans des ampoules à vide d'un disjoncteur relié à un réseau électrique moyenne tension ou haute tension, pour s'assurer du bon fonctionnement du disjoncteur. Pour cela, les systèmes de surveillance utilisent souvent un capteur capacitif qui est placé en vis-à-vis d'une ampoule à vide et qui est associé à une électronique adaptée, le capteur étant capable de détecter une décharge partielle au niveau de l'ampoule. Le fonctionnement est basé sur les caractéristiques diélectriques du vide. En cas d'une perte de vide dans l'ampoule, des amorçages à l'intérieur de l'ampoule se produisent de sorte que le courant circulant dans un capteur capacitif placé en vis-à-vis de l'ampoule génère des impulsions qui sont détectables par le capteur. Ainsi, le courant qui circule à travers ce capteur capacitif est capable de fournir une information représentative de l'état du vide de l'ampoule. Le document CN103413721 permet de déterminer quelle phase est concernée par une décharge partielle.

Cependant, ces systèmes de surveillance ne permettent pas de discriminer entre différents types de décharges partielles qui peuvent être détectés par un tel capteur capacitif. Comme indiqué ci-dessus, le premier type de décharge partielle est une perte du vide dans l'ampoule à vide du disjoncteur sur lequel est implanté le capteur. Mais d'autres types de décharges partielles sont également détectables par un tel capteur capacitif et peuvent provenir de composants du réseau électrique qui sont extérieurs au disjoncteur, comme les câbles du réseau électrique ou d'autres appareils connectés au réseau électrique. Parmi ces autres types de décharges partielles, on peut noter des décharges dues à un effet Corona dans l'air, ou des décharges entre pièces conductrices à potentiel flottant (appelé aussi floating parts in air) par exemple au niveau des câbles, etc...

Donc, les systèmes de surveillance actuels peuvent détecter des décharges partielles qui pourraient être à tort imputées à une perte vide dans des disjoncteurs à vide, alors qu'ils proviennent d'une source extérieure. Ceci n'optimise pas l'efficacité et la maintenance de ces appareils de coupure.

Dans le document JP2014216208A, un algorithme effectue sur les signaux détectés de décharges partielles d'un côté un filtrage sur une fréquence double de la tension, et d'un autre côté un filtrage sur une bande de fréquence 10kHz-100kHz, puis détermine une perte de vide si les deux côtés fournissent un signal supérieur à un certain seuil, sans prendre en compte la polarité des signaux ni l'angle de phase par rapport à la tension phase terre du réseau.

Un but de l'invention est donc de remédier aux inconvénients indiqués ci-dessus et de permettre de mieux différencier de façon la plus simple possible les différents types de décharges partielles détectées. Grâce à l'invention, l'exploitation et la maintenance d'un appareil électrique seront optimisées car il sera possible de faire la différence entre les vraies pertes de vide survenant au niveau du disjoncteur à vide et les autres sources de décharges partielles.

### Exposé de l'invention

Ce but est atteint par un procédé de surveillance de décharges partielles dans un réseau électrique alternatif, le procédé étant mis en oeuvre par un dispositif de surveillance monté dans un appareil de coupure muni d'une ampoule à vide connectée à une phase du réseau alternatif. En particulier, le dispositif de surveillance comprend un détecteur de décharges partielles positionné en vis-à-vis de l'ampoule à vide, et une unité de traitement électronique recevant un premier signal représentatif des décharges partielles détectées par le détecteur, et recevant un second signal représentatif d'une tension dans l'ampoule à vide. Selon l'invention, l'unité de traitement électronique comporte des moyens de comptage capables de comptabiliser durant une durée prédéterminée des impulsions générées par les décharges partielles sur le premier signal, et comporte des moyens de discrimination capables de calculer un angle de phase desdites impulsions par rapport au second signal et capables de déterminer, en fonction de la valeur dudit angle de phase, si les décharges partielles proviennent d'une perte de vide dans l'ampoule à vide.

Grâce à cet angle de phase, les moyens de discrimination déterminent que les décharges partielles proviennent d'une perte de vide dans l'ampoule à vide lorsque l'angle de phase est compris entre -20° et +20°. En dehors de ces valeurs, les décharges partielles proviennent d'une autre cause qu'une perte de vide dans l'ampoule à vide. Par exemple, les décharges partielles proviennent d'un effet Corona lorsque l'angle de phase est compris entre 250° et 290°, et les décharges partielles proviennent d'un effet entre des pièces conductrices à potentiel flottant lorsque l'angle de phase est compris entre 170°et 210°.

Selon un mode de réalisation préféré, le détecteur est un capteur capacitif qui comporte une première surface conductrice séparée par une couche isolante d'une deuxième surface conductrice reliée à la terre, la première surface conductrice étant positionnée en vis-à-vis de l'ampoule à vide.

Par ailleurs, les moyens de discrimination peuvent aussi déterminer que les décharges partielles proviennent d'une perte de vide dans l'ampoule à vide lorsque le nombre d'impulsions négatives est supérieur au nombre d'impulsions positives générées par les décharges partielles sur le premier signal.

L'invention se rapporte également un appareil de coupure, de type disjoncteur ou interrupteur, comportant une ampoule à vide pour chaque phase d'un réseau électrique alternatif multiphases et qui comprend pour chaque phase un tel dispositif de surveillance.

### Brève description des figures

D'autres caractéristiques vont apparaître dans la description détaillée qui suit faite en regard des dessins annexés dans lesquels :
- la figure 1 présente un schéma simplifié d'une ampoule à vide d'un appareil de coupure avec un capteur capacitif placé en vis-à-vis de l'ampoule, dans le cas d'une perte de vide dans l'ampoule,
- la figure 2 montre le même schéma simplifié d'une ampoule à vide dans le cas de décharges partielles survenant en dehors de l'ampoule,
- les figures 3 à 5 montrent des diagrammes de temps représentant sous forme d'histogrammes le nombre de décharges partielles sur une période donnée pour trois types de décharges partielles, à savoir perte de vide pour la figure 3, effet Corona pour la figure 4 et pièces conductrices à potentiel flottant pour la figure 5,
- la figure 6 est un diagramme en coordonnées polaires montrant trois types de décharges partielles pouvant survenir dans une phase et les figures 7 et 8 montrent respectivement ce même diagramme en coordonnées polaires pour deux autres phases. Enfin la figure 9 montre le cas avec un seul capteur pour l'ensemble des trois phases.

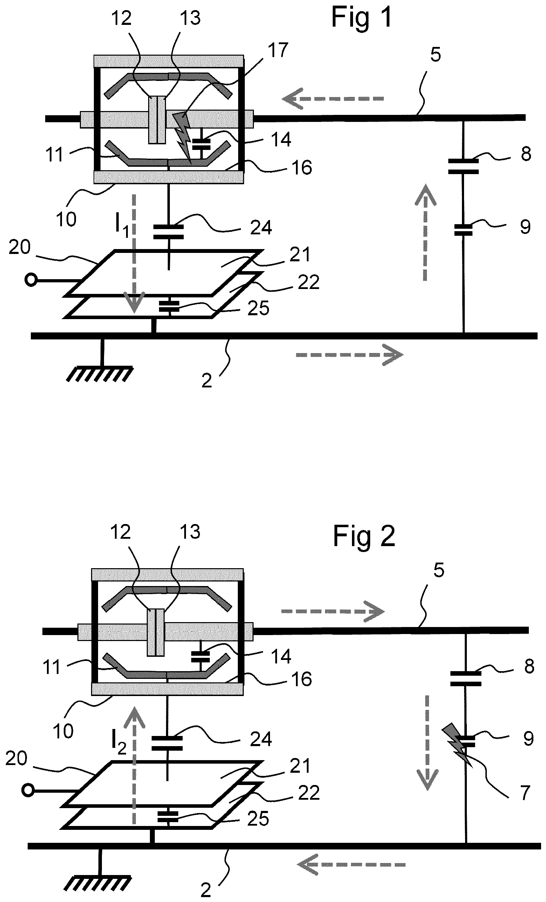

En référence à la figure 1, une ampoule à vide 10 d'un appareil de coupure, tel qu'un interrupteur ou un disjoncteur, comporte deux électrodes de contact 12 et 13 (dont l'une des deux est mobile pour ouvrir ou fermer le contact) raccordées à une phase 5 d'un réseau électrique alternatif multiphases. Dans le mode de réalisation de la figure 1, un écran métallique à potentiel flottant 11 entoure les électrodes 12, 13 de sorte qu'une capacité 14, dite de vide, est formée entre les électrodes 12, 13 et cet écran métallique 11. La valeur de capacité 14 est bien définie et dépend évidemment de la conception de l'ampoule à vide 10. Cependant, en l'absence d'un tel écran métallique 11, on peut aussi envisager que la capacité 14 est déterminée entre les électrodes 12, 13 et la paroi interne 16 de l'ampoule à vide 10.

Le dispositif de surveillance selon l'invention comprend un détecteur de décharges partielles qui est positionné en vis-à-vis de l'ampoule à vide, c'est-à-dire dans une position où il est capable de détecter des décharges partielles survenant dans l'ampoule à vide. Un tel détecteur peut être un capteur capacitif tel que décrit ci-dessous ou tout autre type de détecteur apte à détecter des décharges partielles dans l'ampoule à vide.

Dans le mode de réalisation préféré, le détecteur est un capteur capacitif 20 qui comporte une première surface conductrice 21 et une deuxième surface conductrice 22 séparées l'une de l'autre par une couche isolante. La première surface conductrice 21 est positionnée en vis-à-vis de l'écran métallique 11 de l'ampoule à vide 10 de sorte qu'une première capacité 24 est formée entre la première surface conductrice 21 et l'écran métallique 11 de l'ampoule à vide qui lui fait face. La deuxième surface conductrice 22 est reliée à la terre 2 de sorte qu'une deuxième capacité 25 est formée entre la première surface conductrice 21 et la deuxième surface conductrice 22 reliée à la terre 2.

Les figures 1 et 2 montrent également un schéma équivalent pour les différentes parties isolantes existant entre la phase 5 et la terre 2 et extérieures à l'ampoule à vide 10. Ces parties isolantes sont schématisées de façon simplifiée sous la forme de deux capacités 8, 9 raccordées en série entre la phase 5 et la terre 2.

Lorsqu'une perte partielle de vide survient dans l'ampoule à vide 10, il se produit des amorçages 17 à l'intérieur de l'ampoule entre les électrodes 12, 13 et l'écran 11, de sorte que la capacité 14 est court-circuitée par intermittence. Chaque amorçage augmente la tension sur la capacité 24 et sur la capacité 25 du capteur capacitif 20. L'augmentation de la tension va de pair avec une impulsion de courant I₁ dans le sens phase 5 vers terre 2 et qui traverse le capteur capacitif, comme indiqué par les flèches de la figure 1. Ces impulsions de courant I₁ sont dites en phase avec les amorçages.

Inversement, lorsque des décharges partielles 7 surviennent à l'extérieur de l'ampoule à vide 10 comme indiqué en figure 2, schématisé par exemple au niveau de la capacité 9, ces décharges augmentent par intermittence la tension sur la capacité 8 et sont accompagnés par des impulsions de courant I₂ circulant dans le sens phase 5 vers terre 2 au travers des capacités 8 et 9, comme indiqué par les flèches de la figure 2. Ces impulsions de courant I₂ se rebouclent circulant au travers du capteur capacitif 20 dans le sens terre 2 vers phase 5. Ces impulsions de courant I₂ sont donc de sens inverse que les impulsions de courant I₁ et réduisent la tension sur la capacité 25 du capteur capacitif 20. Elles sont dites être de phase opposée par rapport aux impulsions de courant I₁. Ceci correspond à un déphasage de 180° entre les impulsions de courants I₁ et I₂. Ce déphasage va aider à discriminer l'origine des décharges partielles.

Le dispositif de surveillance comprend également une unité de traitement électronique, non représentée sur les figures, qui est raccordée par un câble à la première surface conductrice 21 du capteur capacitif 20. L'unité de traitement reçoit un premier signal représentatif des variations du courant circulant au travers du capteur 20 et est donc en mesure de détecter les impulsions des courants I₁ ou I₂ lorsque des décharges partielles surviennent. De plus, l'unité de traitement reçoit également un second signal qui est représentatif d'une tension du réseau électrique et de sa fréquence, par exemple la tension 31 entre la phase et la terre dans le mode de réalisation préféré. La tension 31 peut être classiquement obtenue d'un transformateur de mesure de tension ou directement du capteur capacitif 20. Grâce à ce second signal, l'unité de traitement peut avantageusement synchroniser les décharges partielles détectées à l'aide du premier signal et déterminer ainsi le déphasage entre les décharges partielles détectées et la tension phase-terre de l'ampoule à vide 10. De façon équivalente, le dispositif de surveillance pourrait recevoir un second signal représentatif de la tension entre deux phases au lieu de la tension phase-terre ou un signal représentatif de la tension entre une autre des trois phases et la terre.

L'unité de traitement comporte des moyens de comptage pour comptabiliser les décharges partielles détectées à l'aide du premier signal durant une durée prédéterminée suffisamment grande pour obtenir des mesures significatives et pour s'affranchir notamment d'éventuels parasites. En effet, les décharges partielles donnent lieu à des impulsions sur le premier signal qui sont très brèves en regard de la fréquence de 50Hz du réseau électrique et qui surviennent un grand nombre de fois durant une période du réseau. Il est donc préférable de les comptabiliser pour pouvoir mieux les exploiter. Un exemple de durée est de compter les décharges partielles durant un cycle de 100 périodes de 20 msec (pour un réseau alternatif de 50Hz). Cette durée de 2 secondes est suffisante pour diagnostiquer une perte de vide. Néanmoins, pour éviter tout aléa, le diagnostic de perte de vide est de préférence confirmé après répétition de 5 cycles de mesure de 100 périodes. La fréquence de répétition de chaque cycle de mesure est variable. Elle peut être de toutes les 2 secondes au maximum ou typiquement toutes les minutes. Donc, ceci porte la durée d'un diagnostic de perte de vide de 10 secondes minimum à typiquement à 5 minutes. D'autres durées sont évidemment envisageables, notamment des durées plus grandes pour cumuler un nombre plus important de mesures.

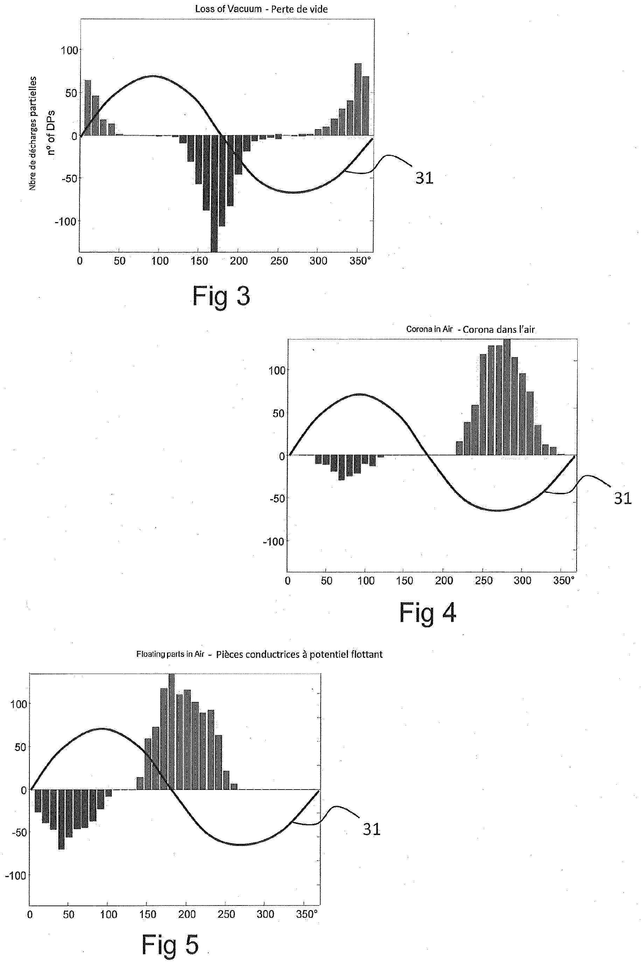

Les résultats des calculs réalisés par l'unité de traitement sont montrés dans les graphes des figures 3 à 5. Ces graphes sont des histogrammes qui donnent le nombre de décharges partielles détectées durant la durée prédéterminée en fonction de leur déphasage par rapport à la tension phase-terre mesurée 31. Ces histogrammes déterminent ainsi une signature propre à chaque type de décharges partielles. En analysant ces graphes, il est possible d'identifier le type de décharge partielle détectée par le dispositif de surveillance, en particulier de discriminer les décharges partielles dues à une perte de vide dans l'ampoule 10 située en vis-à-vis du capteur capacitif 20 de celles dues à une autre cause.

Sur ces graphes, l'abscisse correspond à l'angle de phase de la tension mesurée V (référencée 31) sur une période pleine de 0° à 360°, divisée par segments de 10°. L'ordonnée correspond au nombre de décharge s partielles comptabilisé durant la durée prédéterminée des mesures pour chaque segment de 10°du déphasage avec la tension phase-terre 31 et selon la polarité ou le signe des décharges. Les décharges partielles sont en effet comptées séparément suivant qu'elles sont positives ou négatives; c'est-à-dire suivant que les impulsions générées par les décharges partielles et détectées dans le premier signal sont positives ou négatives, elles sont comptabilisées positives ou négatives.

Ainsi un seul angle de phase peut être attribué à l'ensemble des décharges partielles détectées. Préférentiellement cet angle de phase est obtenu par transformation de Fourier de la somme des impulsions positives et négatives en utilisant la phase de la première harmonique. Alternativement, comme on remarque sur tous les graphes que le nombre de décharges partielles positives et négatives affiche un comportement aléatoire, ceci peut être décrit par une courbe de Gauss caractérisée par une valeur centrale dominante d'angle de phase; cet angle de phase peut être obtenu par transformation de Fourier de chaque distribution en respectant la comptabilisation associée.

L'unité de traitement comporte des moyens de discrimination qui calculent l'angle de phase des impulsions du premier signal par rapport au second signal sinusoïdal de la tension phase-terre 31. Le déphasage de ces impulsions par rapport à la tension phase-terre sera suffisant pour discriminer l'origine des décharges partielles détectées sur le premier signal et notamment déterminer si les décharges partielles proviennent ou non d'une perte de vide dans l'ampoule 10. La solution apportée par l'invention est donc très simple à mettre en oeuvre puisque la valeur de l'angle de phase permet de déterminer les différentes origines possibles des décharges partielles détectées sans nécessiter d'autres calculs plus complexes, comme le montre les paragraphes suivants.

Le graphe de la figure 3 montre ainsi le cas des décharges partielles qui ont comme origine une perte de vide dans l'ampoule située en vis-à-vis du capteur capacitif comme présenté en figure 1. Dans ce cas, les impulsions générées par ces décharges partielles sont positives aux alentours du passage à 0°de la période, c'est-à-dire lorsque l'angle de phase est majoritairement compris entre -20° et +20° par rapport à la tension phase-terre 31, et sont négatives aux alentours du passage à 180° de la période. Au niveau du capteur 20, les impulsions négatives sont dans ce cas plus nombreuses que les impulsions positives. Ca signifie que, dans ce cas, le procédé de surveillance mis en oeuvre par le dispositif de surveillance détermine donc que les décharges partielles proviennent d'une perte de vide dans l'ampoule à vide 10 lorsque l'angle de phase est sensiblement compris entre -20°et +20°.

Le graphe de la figure 4 montre des décharges partielles qui sont extérieures à l'ampoule à vide 10 et qui proviennent d'un effet Corona dans l'air. Dans ce cas, les impulsions générées par ces décharges partielles sont maximales lors des valeurs maximales de la tension phase-terre 31. Les impulsions sont positives à la source (représentée schématiquement par la capacité 9) aux alentours du passage à 90°de la période, c'est-à-dire entre 70° et 110°, mais sont détectés négatives au niveau du capteur capacitif 20. Les impulsions sont négatives à la source aux alentours d'un angle de 270° de la période, c'est-à-dire lorsque l'angle de phase est majoritairement compris entre 250° et 290° par rapport à la tension phase-terre 31, mais sont détectés positives au niveau du capteur capacitif 20. On constate facilement que le signal composé des décharges partielles positives et négatives est en phase opposée par rapport à la fréquence industrielle de la tension 31. Au niveau du capteur 20, les impulsions positives sont dans ce cas beaucoup plus nombreuses que les impulsions négatives. Ca signifie que, dans ce cas, le procédé de surveillance mis en oeuvre par le dispositif de surveillance détermine donc que les décharges partielles proviennent d'un effet Corona lorsque l'angle de phase est sensiblement compris entre 250° et 290°.

Le graphe de la figure 5 montre des décharges partielles qui sont extérieures à l'ampoule à vide 10 et qui surviennent entre pièces conductrices à potentiel flottant, par exemple au niveau des câbles, comme présenté en figure 2. Les impulsions sont positives à la source (représentée schématiquement par la capacité 9) aux alentours du passage à 50° de la période, c'est-à-dire entre 30° et 70°, mais sont détectés négatives par le capteur capacitif 20. Les impulsions sont négatives à la source aux alentours d'un angle de 190° de la période, c'est-à-dire lorsque l'angle de phase est majoritairement compris entre 170° et 210° par rapport à la tension phase-terre 31, mais sont détectés positives par le capteur capacitif 20. On constate facilement que le signal composé des décharges partielles positives et négatives est décalé en phase par rapport à la fréquence industrielle de la tension 31 et en opposition avec les décharges partielles dû à une perte de vide de la figure 3. Au niveau du capteur 20, les impulsions positives sont dans ce cas plus nombreuses que les impulsions négatives. Ca signifie que, dans ce cas, le procédé de surveillance mis en oeuvre par le dispositif de surveillance détermine donc que les décharges partielles surviennent entre des pièces conductrices à potentiel flottant lorsque l'angle de phase est sensiblement compris entre 170° et 210°.

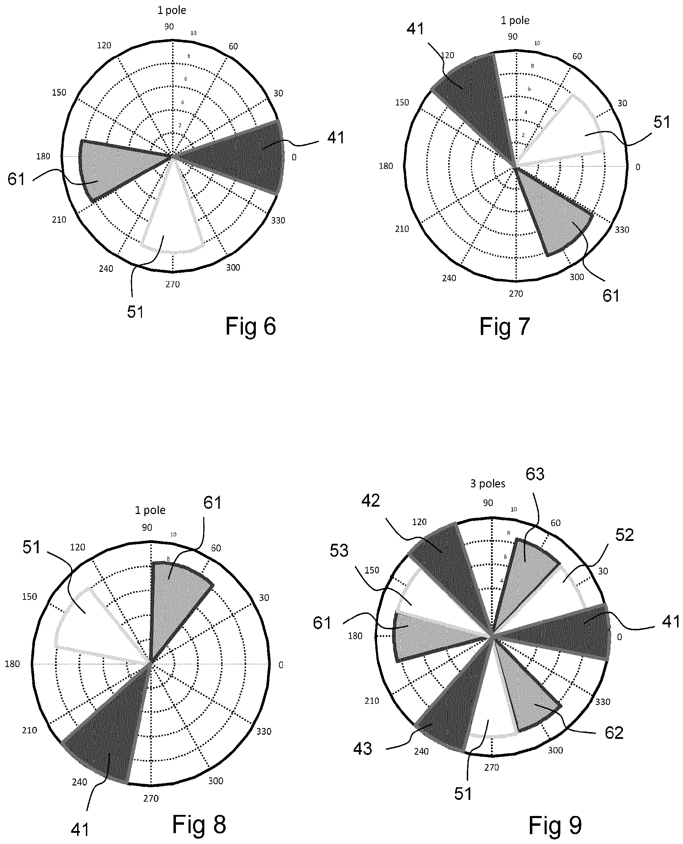

La figure 6 est un diagramme en coordonnées polaires qui reprend les résultats des figures 3 à 5 et montre les trois types de décharges partielles pouvant survenir dans une des phases du réseau électrique. Chaque type de décharges partielles est représenté par un cône de valeurs qui entoure une valeur centrale dominante d'angle de phase pour les impulsions positives générées par ces décharges partielles. Ainsi, le cône 41 est représentatif de décharges partielles provenant d'une perte de vide dans l'ampoule, car centré autour d'un angle de phase égal à 0°. Le cône 51 est représentatif de décharges partielles provenant d'un effet Corona dans l'air, car centré autour d'un angle de phase égal à 270°. Le cône 61 est représentatif de décharges partielles provenant d'une pièce conductrice à potentiel flottant dans l'air, car centré autour d'un angle de phase égal à 190°.

Dans les figures ci-dessus, on a considéré que les impulsions devaient se trouver majoritairement dans un cône ayant 40° de largeur, c'est-à-dire +/-20° autour de la valeur centrale dominante. Néanmoins, en fonction de la qualité des mesures effectuées, ce cône peut tout à fait être élargi à +/-30° autour de la valeur centrale dominante, car cela resterait suffisant pour déterminer l'origine des décharges partielles détectées par le capteur capacitif 20. Par exemple, si l'angle de phase des impulsions positives est compris entre -30° et +30° autour de 0°, les décharges partielles seront aussi considérées comme provenant d'une perte de vide dans l'ampoule. Ca signifie que, dans ce cas, le procédé de surveillance mis en oeuvre par le dispositif de surveillance détermine donc que les décharges partielles proviennent d'une perte de vide dans l'ampoule à vide lorsque l'angle de phase est sensiblement compris entre -30°et +30°.

Dans le mode de réalisation préféré décrit ci-dessus, l'angle de phase peut être obtenu à partir d'une transformation de Fourier de la totalité des décharges partielles, ce qui fournit un paramètre pertinent pour calculer l'angle de phase car c'est généralement suffisant pour déterminer l'origine des décharges partielles, en particulier pour discriminer si elles proviennent ou non d'une perte de vide dans l'ampoule située en vis-à-vis du capteur. Cela permet ainsi d'obtenir une méthode très simple à mettre en oeuvre dans le dispositif de surveillance. Cependant, d'autres paramètres peuvent aussi être utiles si nécessaire.

Parmi ces autres paramètres, on peut prendre par exemple le paramètre Q qui exprime l'asymétrie des décharges partielles. Le paramètre Q peut être simplifié comme le ratio entre le nombre d'impulsions positives et le nombre d'impulsions négatives détectées durant la durée prédéterminée au niveau du capteur 20 (voir document de Edward Gulski, «Computer-Aided Recognition of PD Using Statistical Tools», Delft University Press, Netherlands, 14 october 1991). Par exemple, une perte de vide dans l'ampoule à vide correspond à un ratio Q inférieur à un seuil prédéterminé environ égal à 1, c'est-à-dire quand le nombre d'impulsions négatives est supérieur au nombre d'impulsions positives. A l'inverse, des décharges partielles dues à une cause externe à l'ampoule à vide donnent un ratio Q supérieur à ce seuil, c'est-à-dire quand le nombre d'impulsions positives est supérieur au nombre d'impulsions négatives. De plus, les décharges partielles dues à un effet Corona ont un ratio Q très supérieur aux décharges partielles dues à des pièces conductrices à potentiel flottant. Ca signifie que, dans ce cas, le procédé de surveillance détermine que les décharges partielles proviennent d'une perte de vide dans l'ampoule à vide 10 lorsque le nombre d'impulsions négatives est supérieur au nombre d'impulsions positives générées par les décharges partielles sur le premier signal.

Le dispositif de surveillance peut être utilisé dans un réseau alternatif triphasé pour un disjoncteur à vide comportant donc trois ampoules à vide et trois capteurs capacitifs. Préférentiellement, un tel disjoncteur à vide utilise un dispositif de surveillance ayant trois capteurs capacitifs mais une seule unité de traitement électronique commune. Cette unité de traitement reçoit donc du capteur capacitif de chaque phase un premier signal représentatif de décharges partielles et reçoit également, pour chaque ampoule à vide, un second signal représentatif de la tension entre l'ampoule à vide et la terre. Dans ce cas, l'unité de traitement du disjoncteur à vide génère trois diagrammes identiques à celui de la figure 6, c'est-à-dire un diagramme pour chaque ampoule à vide.

On pourrait aussi considérer de façon simplifiée que l'unité de traitement ne reçoit qu'un seul second signal représentatif de la tension entre une des ampoules à vide et la terre, ce qui simplifie la conception du dispositif de surveillance. Dans ce cas, l'unité de traitement du disjoncteur à vide génère un premier diagramme identique à la figure 6 pour une première ampoule à vide, un deuxième diagramme similaire mais décalé de 120° pour une deuxième ampoule à vide tel qu'indiqué en figure 7 et un troisième diagramme similaire mais décalé de 240°p our une troisième ampoule à vide tel qu'indiqué en figure 8.

Enfin, la figure 9 montre un diagramme en coordonnées polaires qui reprend les mêmes résultats de la figure 6 mais les présente au niveau des trois phases d'un disjoncteur triphasé. Cet exemple correspond au cas où le dispositif de surveillance comprend un seul capteur pour les trois ampoules à vide d'un disjoncteur et un seul second signal représentatif de la tension entre une des ampoules à vide et la terre. Les cônes 41, 51, 61 correspondent à une première phase du réseau électrique, les cônes 42, 52, 62 correspondent à une deuxième phase du réseau électrique et les cônes 43, 53, 63 correspondent à une troisième phase du réseau électrique, ces groupes de trois cônes correspondant respectivement à une perte de vide dans l'ampoule de la phase, un effet Corona et une pièce conductrice à potentiel flottant. Dans cet exemple, il est préférable rétrécir les cônes à environ 30° de largeur, c'est-à-dire rétrécir à +/-15° autour de la valeur centrale dominante, pour éviter les chevauchements et mieux distinguer les différents secteurs.

L'unité de traitement peut être intégrée dans un module électronique qui est monté par exemple sur un rail DIN au niveau de la partie avant d'un disjoncteur à vide et qui intègre aussi une alimentation électrique pour l'unité de traitement. L'unité de traitement comporte des moyens connus permettant de numériser, filtrer et amplifier les signaux analogiques provenant des capteurs et comporte bien entendu une mémoire pour stocker les informations reçues et/ou les informations calculées. Par ailleurs, le module électronique peut également comporter une interface Homme-Machine et une interface de communication réseau filaire ou sans-fil, de façon à pouvoir signaler et transmettre les événements/alarmes détectés par le dispositif de surveillance.

## Revendications

1. Procédé de surveillance de décharges partielles dans un réseau électrique alternatif, le procédé étant mis en oeuvre par un dispositif de surveillance monté dans un appareil de coupure muni d'une ampoule à vide (10) connectée à une phase (5) du réseau alternatif, le dispositif de surveillance comprenant :
- un détecteur de décharges partielles positionné en vis-à-vis de l'ampoule à vide (10),
- une unité de traitement électronique recevant un premier signal représentatif des décharges partielles détectées par ledit détecteur, et recevant un second signal représentatif d'une tension (31) du réseau électrique alternatif,
- l'unité de traitement électronique comportant des moyens de comptage capables de comptabiliser durant une durée prédéterminée des impulsions générées par les décharges partielles sur le premier signal,
- l'unité de traitement électronique comportant des moyens de discrimination capables de calculer un angle de phase desdites impulsions par rapport au second signal,
**caractérisé en ce que** le procédé de surveillance détermine que les décharges partielles proviennent d'une perte de vide dans l'ampoule à vide (10) lorsque l'angle de phase est compris entre -30° et +30° ou lorsque le nombre d'impulsions négatives est supérieur au nombre d'impulsions positives générées par les décharges partielles sur le premier signal.

2. Procédé de surveillance de décharges partielles selon la revendication 1, **caractérisé en ce que** le procédé de surveillance détermine que les décharges partielles proviennent d'une perte de vide dans l'ampoule à vide (10) lorsque l'angle de phase est compris entre -20° et +20°.

3. Procédé de surveillance de décharges partielles selon la revendication 1, **caractérisé en ce que** le procédé de surveillance détermine que les décharges partielles proviennent d'un effet Corona lorsque l'angle de phase est compris entre 250° et 290°.

4. Procédé de surveillance de décharges partielles selon la revendication 1, **caractérisé en ce que** le procédé de surveillance détermine que les décharges partielles surviennent entre des pièces conductrices à potentiel flottant lorsque l'angle de phase est compris entre 170° et 210°.

5. Dispositif de surveillance de décharges partielles dans un réseau électrique alternatif, le dispositif de surveillance étant monté dans un appareil de coupure muni d'une ampoule à vide (10) connectée à une phase (5) du réseau alternatif, le dispositif de surveillance comprenant :
- un détecteur de décharges partielles positionné en vis-à-vis de l'ampoule à vide (10),
- une unité de traitement électronique recevant un premier signal représentatif des décharges partielles détectées par ledit détecteur et recevant un second signal représentatif d'une tension (31) du réseau électrique alternatif,
- l'unité de traitement électronique comportant des moyens de comptage capables de comptabiliser durant une durée prédéterminée des impulsions générées par les décharges partielles sur le premier signal,
- l'unité de traitement électronique comportant des moyens de discrimination capables de calculer un angle de phase desdites impulsions par rapport au second signal,
**caractérisé en ce que** l'unité de traitement est susceptible de mettre en oeuvre le procédé de surveillance selon l'une des revendications précédentes.

6. Dispositif de surveillance selon la revendication 5, **caractérisé en ce que** le détecteur de décharges partielles est un capteur capacitif (20) comportant une première surface conductrice (21) séparée par une couche isolante d'une deuxième surface conductrice (22) reliée à la terre, la première surface conductrice (21) étant positionnée en vis-à-vis de l'ampoule à vide (10).

7. Appareil de coupure comportant une ampoule à vide pour chaque phase d'un réseau électrique alternatif multiphases, **caractérisé en ce que** l'appareil de coupure comprend pour chaque phase un dispositif de surveillance selon l'une des revendications 5 à 6.

## Patentansprüche

1. Verfahren zur Überwachung von Teilentladungen in einem Wechselstromnetz, wobei das Verfahren von einer Überwachungsvorrichtung durchgeführt wird, die in einem Schaltgerät angebracht ist, das mit einer Vakuumröhre (10) ausgestattet ist, die mit einer Phase (5) des Wechselstromnetzes verbunden ist, wobei die Überwachungsvorrichtung umfasst:
- einen Teilentladungsdetektor, der gegenüber der Vakuumröhre (10) positioniert ist,
- eine elektronische Verarbeitungseinheit, die ein erstes Signal empfängt, das für die von dem Detektor detektierten Teilentladungen repräsentativ ist, und ein zweites Signal empfängt, das für eine Spannung (31) des Wechselstromnetzes repräsentativ ist,
- wobei die elektronische Verarbeitungseinheit Zählmittel aufweist, die in der Lage sind, während einer vorbestimmten Dauer Impulse zu zählen, die durch die Teilentladungen auf dem ersten Signal erzeugt werden,
- wobei die elektronische Verarbeitungseinheit Diskriminationsmittel aufweist, die in der Lage sind, einen Phasenwinkel der Impulse bezüglich des zweiten Signals zu berechnen,
**dadurch gekennzeichnet, dass** das Verfahren zur Überwachung bestimmt, dass die Teilentladungen von einem Vakuumverlust in der Vakuumröhre (10) herrühren, wenn der Phasenwinkel zwischen -30° und +30° liegt oder wenn die Anzahl negativer Impulse größer als die Anzahl positiver Impulse ist, die durch die Teilentladungen auf dem ersten Signal erzeugt werden.

2. Verfahren zur Überwachung von Teilentladungen nach Anspruch 1, **dadurch gekennzeichnet, dass** das Verfahren zur Überwachung bestimmt, dass die Teilentladungen von einem Vakuumverlust in der Vakuumröhre (10) herrühren, wenn der Phasenwinkel zwischen -20° und +20° liegt.

3. Verfahren zur Überwachung von Teilentladungen nach Anspruch 1, **dadurch gekennzeichnet, dass** das Verfahren zur Überwachung bestimmt, dass die Teilentladungen von einem Korona-Effekt herrühren, wenn der Phasenwinkel zwischen 250° und 290° liegt.

4. Verfahren zur Überwachung von Teilentladungen nach Anspruch 1, **dadurch gekennzeichnet, dass** das Verfahren zur Überwachung bestimmt, dass die Teilentladungen zwischen leitenden Teilen mit schwebendem Potential auftreten, wenn der Phasenwinkel zwischen 170° und 210° liegt.

5. Vorrichtung zur Überwachung von Teilentladungen in einem Wechselstromnetz, wobei die Überwachungsvorrichtung in einem Schaltgerät angebracht ist, das mit einer Vakuumröhre (10) ausgestattet ist, die mit einer Phase (5) des Wechselstromnetzes verbunden ist, wobei die Überwachungsvorrichtung umfasst:
- einen Teilentladungsdetektor, der gegenüber der Vakuumröhre (10) positioniert ist,
- eine elektronische Verarbeitungseinheit, die ein erstes Signal empfängt, das für die von dem Detektor detektierten Teilentladungen repräsentativ ist, und ein zweites Signal empfängt, das für eine Spannung (31) des Wechselstromnetzes repräsentativ ist,
- wobei die elektronische Verarbeitungseinheit Zählmittel aufweist, die in der Lage sind, während einer vorbestimmten Dauer Impulse zu zählen, die durch die Teilentladungen auf dem ersten Signal erzeugt werden,
- wobei die elektronische Verarbeitungseinheit Diskriminationsmittel aufweist, die in der Lage sind, einen Phasenwinkel der Impulse bezüglich des zweiten Signals zu berechnen,
**dadurch gekennzeichnet, dass** die Verarbeitungseinheit geeignet ist, das Verfahren zur Überwachung nach einem der vorhergehenden Ansprüche durchzuführen.

6. Vorrichtung zur Überwachung nach Anspruch 5, **dadurch gekennzeichnet, dass** der Teilentladungsdetektor ein kapazitiver Sensor (20) ist, der eine erste leitende Fläche (21) aufweist, die durch eine isolierende Schicht von einer zweiten leitenden Fläche (22) getrennt ist, die mit Erde verbunden ist, wobei die erste leitende Fläche (21) gegenüber der Vakuumröhre (10) positioniert ist.

7. Schaltgerät, welches eine Vakuumröhre für jede Phase eines mehrphasigen Wechselstromnetzes aufweist, **dadurch gekennzeichnet, dass** das Schaltgerät für jede Phase eine Vorrichtung zur Überwachung nach einem der Ansprüche 5 bis 6 umfasst.

## Claims

1. Method for monitoring partial discharges in an AC electrical network, the method being implemented by a monitoring device mounted in a switching apparatus provided with a vacuum bottle (10) connected to one phase (5) of the AC network, the monitoring device including:
- a partial discharge detector positioned facing the vacuum bottle (10),
- an electronic processing unit receiving a first signal representative of the partial discharges detected by said detector, and receiving a second signal representative of a voltage (31) of the AC electrical network,
- the electronic processing unit comprising counting means which are capable of counting during a predetermined duration the pulses generated by the partial discharges on the first signal,
- the electronic processing unit comprising discriminating means which are capable of calculating a phase angle of said pulses with respect to the second signal,
**characterized in that** the monitoring method determines that the partial discharges originate from a loss of vacuum in the vacuum bottle (10) when the phase angle is between -30° and +30° or when the number of negative pulses is greater than the number of positive pulses generated by the partial discharges on the first signal.

2. Method for monitoring partial discharges according to Claim 1, **characterized in that** the monitoring method determines that the partial discharges originate from a loss of vacuum in the vacuum bottle (10) when the phase angle is between -20° and +20°.

3. Method for monitoring partial discharges according to Claim 1, **characterized in that** the monitoring method determines that the partial discharges originate from a corona effect when the phase angle is between 250° and 290°.

4. Method for monitoring partial discharges according to Claim 1, **characterized in that** the monitoring method determines that the partial discharges occur between conductive parts at floating potential when the phase angle is between 170° and 210°.

5. Device for monitoring partial discharges in an AC electrical network, the monitoring device being mounted in a switching apparatus provided with a vacuum bottle (10) connected to one phase (5) of the AC network, the monitoring device including:
- a partial discharge detector positioned facing the vacuum bottle (10),
- an electronic processing unit receiving a first signal representative of the partial discharges detected by said detector, and receiving a second signal representative of a voltage (31) of the AC electrical network,
- the electronic processing unit comprising counting means which are capable of counting during a predetermined duration the pulses generated by the partial discharges on the first signal,
- the electronic processing unit comprising discriminating means which are capable of calculating a phase angle of said pulses with respect to the second signal,
**characterized in that** the processing unit is able to implement the monitoring method according to one of the preceding claims.

6. Monitoring device according to claim 5, **characterized in that** the partial discharge detector is a capacitive sensor (20) comprising a first conductive surface (21) separated by an insulating layer from a second conductive surface (22) connected to earth, the first conductive surface (21) being positioned facing the vacuum bottle (10).

7. Switching apparatus comprising a vacuum bottle for each phase of a multiphase AC electrical network, **characterized in that** the switching apparatus includes for each phase a monitoring device according to one of claims 5 to 6.
